# EUROPEAN PATENT APPLICATION

(11) **EP 4 376 562 A1**
(43) Date of publication of application: **29.05.2024**
(21) Application number: 22845957.4
(22) Date of filing: 20.07.2022
(51) Int. Cl.: H05K 3/46, H05K 3/40

(54) **WIRING SUBSTRATE**

(30) Priority: 20.07.2021 JP 2021119921
(71) Applicant: Kyocera Corporation, Kyoto-shi Kyoto 612-8501 (JP)
(72) Inventor: MATSUMOTO, Yuhei, Kyoto-shi, Kyoto 612-8501 (JP); YAMAMOTO, Sentarou, Kyoto-shi, Kyoto 612-8501 (JP); OKAMOTO, Kazuhiro, Kyoto-shi, Kyoto 612-8501 (JP)
(74) Representative: Viering, Jentschura & Partner mbB Patent- und Rechtsanwälte
(86) International application number: PCT/JP2022/028241
(87) International publication number: WO 2023/003024

(57) **Abstract**

In a wiring board, a first substrate (10), a surface electrical conductor layer (12), and a second substrate (20) are laminated in this order. The second substrate (20) contains an organic material as an insulating base material. The surface electrical conductor layer (12) is located on a surface of the first substrate (20), and the second substrate (20) includes a plurality of interlayer connection conductors (22). The insulating base material of the second substrate (20) includes a first region (211) and a second region (212). The first region (211) is located on the surface electrical conductor layer. The second region (212) is located on the surface of the first substrate. The first region (211) has a lower ratio of voids and pores than the second region (212).

## Description

### TECHNICAL FIELD

An embodiment of the present disclosure relates to a wiring board.

### BACKGROUND OF INVENTION

A wiring board has been proposed in which a plurality of circuits made of an organic resin are laminated on a substrate made of ceramic. The circuit includes a plurality of connection conductors penetrating between the laminated layers.

### CITATION LIST

### PATENT LITERATURE

Patent Document 1: JP 2019-207977 A

### SUMMARY

In a wiring board according to an aspect of an embodiment, a first substrate, a surface electrical conductor layer, and a second substrate are laminated in this order. The second substrate contains an organic material as an insulating base material. The surface electrical conductor layer is located on a surface of the first substrate. The second substrate includes a plurality of interlayer connection conductors. The interlayer connection conductor extends in a thickness direction of the second substrate, and has one end exposed from a surface of the second substrate. The surface electrical conductor layer and the interlayer connection conductor are electrically connected to each other. The insulating base material of the second substrate includes a first region and a second region. The first region is located on the surface electrical conductor layer. The second region is located on the surface of the first substrate. The first region has a greater density than a density of the second region.

### BRIEF DESCRIPTION OF THE DRAWINGS

FIG. 1 is a cross-sectional view illustrating an example of a wiring board according to a first embodiment.
FIG. 2 is a cross-sectional view illustrating an example of the wiring board according to a second embodiment.
FIG. 3 is a cross-sectional view illustrating an example of the wiring board according to a third embodiment.
FIG. 4 is an enlarged plan view illustrating a part of the wiring board illustrated in FIG. 3.
FIG. 5 is a cross-sectional view illustrating an example of the wiring board according to a fourth embodiment.
FIG. 6 is a cross-sectional view illustrating an example of the wiring board according to a fifth embodiment.
FIG. 7 is a cross-sectional view illustrating another example of the wiring board according to an embodiment.
FIG. 8 is a cross-sectional view illustrating another example of the wiring board according to an embodiment.
FIG. 9 is an explanatory diagram illustrating an example of a method of manufacturing the wiring board according to Sample 1.
FIG. 10 is a plan view illustrating wiring boards according to Samples 1 to 6.
FIG. 11 is a diagram showing evaluation results of the wiring boards according to Samples 1 to 6.

### DESCRIPTION OF EMBODIMENTS

Modes (hereinafter referred to as "embodiments") for implementing a wiring board according to the present disclosure will be described in detail below with reference to the accompanying drawings. Note that the wiring board according to the present disclosure is not limited by the embodiments. Embodiments can be appropriately combined so as not to contradict each other in terms of processing content.

### First Embodiment

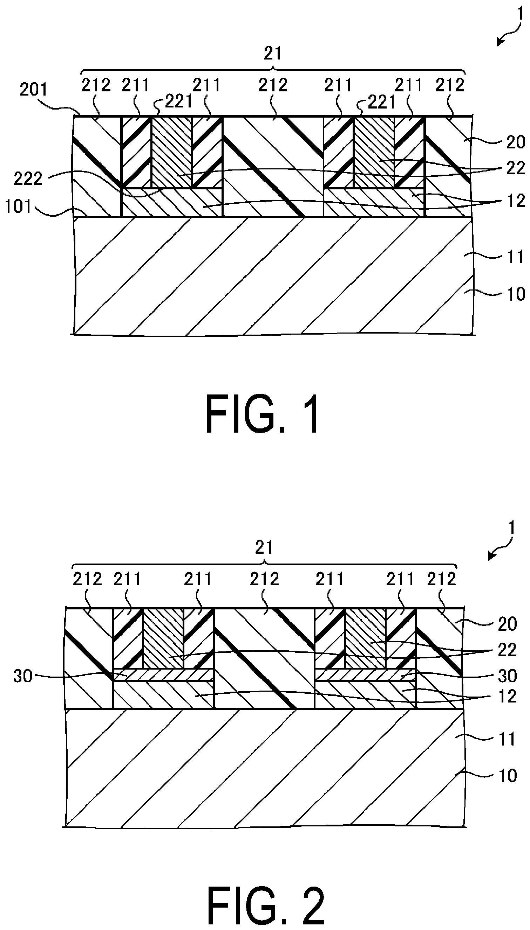

FIG. 1 is a cross-sectional view illustrating an example of a wiring board according to a first embodiment.

As illustrated in FIG. 1, a wiring board 1 according to the first embodiment includes a first substrate 10 and a second substrate 20. The first substrate 10 includes an insulating base material 11 and a surface electrical conductor layer 12.

The insulating base material 11 is, for example, a ceramic base material made of ceramic. The insulating base material 11 may be, for example, an alumina-based or glass ceramic-based ceramic, a dielectric such as cordierite, zirconia, barium titanate, strontium titanate, or calcium titanate, aluminum titanate, or lead zirconate titanate (PZT). The insulating base material 11 may include, for example, a plurality of ceramics.

The surface electrical conductor layer 12 is located on a surface of the insulating base material 11. The surface electrical conductor layer 12 protrudes from a surface 101 of the first substrate 10. The surface electrical conductor layer 12 may be, for example, wiring having a linear shape, a pad having a circular shape, a quadrilateral shape, or another angular shape, or a power supply layer or a ground layer having a solid shape. For example, the surface electrical conductor layer 12 may be smaller than the area of a main surface of the first substrate 10.

FIG. 1 illustrates an example in which the surface electrical conductor layer 12 protrudes from the surface 101 of the first substrate 10 by a thickness corresponding to the thickness of the surface electrical conductor layer 12. However, the surface electrical conductor layer 12 may protrude from the surface 101 of the first substrate 10 to a lesser extent than the thickness of the surface electrical conductor layer 12. The surface electrical conductor layer 12 may protrude from the surface 101 of the first substrate 10, for example, by 1/3 or more of an average thickness of the surface electrical conductor layer 12.

The surface electrical conductor layer 12 may be a conductor made of tungsten (W), molybdenum (Mo), a mixture of W-Mo, an alloy of W-Mo, an intermetallic compound of W-Mo, copper (Cu), silver (Ag), nickel (Ni), or the like. The surface electrical conductor layer 12 may contain ceramic powder or the like.

The second substrate 20 is located on the first substrate 10. The second substrate 20 includes an insulating base material 21 and a plurality of interlayer connection conductors 22.

The insulating base material 21 is, for example, a so-called organic base material containing an organic material. The insulating base material 21 may be, for example, an epoxy resin, an acrylic resin, a polycarbonate resin, a polyimide resin, an olefin resin, or a polyphenylene resin. The insulating base material 21 may be, for example, polytetrafluoroethylene (PTFE) or any other fluororesin, or a polyphenylene ether resin.

The interlayer connection conductor 22 has one end 221 and another end 222, and extends in a thickness direction of the second substrate 20. The one end 221 is positioned so as to be exposed from a surface 201 of the second substrate 20. The other end 222 is electrically connected to the surface electrical conductor layer 12.

The interlayer connection conductor 22 may contain, for example, copper powder, tin (Sn) powder, or bismuth (Bi) powder. In the interlayer connection conductor 22, a ratio of the metal component such as copper, tin, and bismuth described above is preferably 60% or more and 90% or less in terms of the volume ratio. When the ratio of the metal component is in such a range, the electrical conductivity of the interlayer connection conductor 22 can be improved. The adhesiveness of the interlayer connection conductor 22 to the insulating base material 21 and the surface electrical conductor layer 12 can also be improved. Note that the ratio of the metal component contained in the interlayer connection conductor 22 may be calculated as an area ratio of a cross section of the interlayer connection conductor 22 by using, for example, an electron microscope equipped with an analyzer. In this case, the calculated area ratio may be regarded as the volume ratio. In the case of the interlayer connection conductor 22, the amount of copper is preferably equal to the total amount of tin and bismuth. Tin and bismuth are preferably contained in the same amount. The interlayer connection conductor 22 may contain the same material as that of the insulating base material 21 such as an epoxy resin, as a remaining portion thereof.

The insulating base material 21 includes a first region 211 and a second region 212. The first region 211 is a portion of the insulating base material 21 located on the surface electrical conductor layer 12. The second region 212 is a portion of the insulating base material 21, other than the first region 211, located on the first substrate 10. The first region 211 has a greater density than the second region 212. Examples of a method of evaluating the density include a method of calculating the number of voids located in the first region 211 and the second region 212 or a ratio of the total area of voids, and a method of cutting out a portion of each of the first region 211 and the second region 212 and measuring the density of the cut-out portions. Among these methods, the method of calculating the ratio of the total area of voids present in a region of a unit area is preferable. This is because a difference is likely to occur even in an extremely small region.

As described above, in the wiring board 1, the density of the first region 211, which is the insulating base material 21 located on the surface electrical conductor layer 12, is greater than the density of the second region 212, which is the insulating base material 21 located on the first substrate 10 on which the surface electrical conductor layer 12 is not located. Thus, for example, in the wiring board 1 in which a plurality of interlayer connection conductors 22 are located in the insulating base material 21 of the second substrate 20, moisture is less likely to enter the interlayer connection conductors 22. As a result, the wiring board 1 can reduce a deterioration in the insulation resistance.

More specifically, the density of the first region 211 may be 1.1 times or more the density of the second region 212, for example. Such a density can be calculated by the Archimedes method using a sample obtained by cutting out the wiring board 1. Alternatively, the density may be calculated from the dimensions and mass of the cut-out sample. In this case, the shape of the sample is preferably a hexahedron.

Instead of the density of the insulating base material 21, the denseness of the first region 211 and the second region 212 may be evaluated based on the magnitude of the porosity of the insulating base material 21. The denseness of the first region 211 and the second region 212 can be more easily analyzed when the denseness is calculated from the porosity rather than from the density.

The porosity is evaluated in the following manner. First, a photograph of a cross section of the wiring board 1 is taken, and the first region 211 and the second region 212 are determined in the photograph. Subsequently, a region having a specific area is specified from each of the determined locations. Subsequently, the total area of voids observed in the cross section of each of the specified regions is calculated. When the specified area is A0 and the total area of voids is A1, an A1/A0 ratio is calculated. An area to be analyzed may be appropriately set in an area range of, for example, 10 µm × 10 µm to 100 µm × 100 µm in accordance with the thickness of the second substrate 20 and the interval between the interlayer connection conductors 22. When the porosity of the first region 211 is P1 and the porosity of the second region 212 is P2, P1/P2 is preferably 0.95 or less.

The first substrate 10 may include, for example, an electrical conductor layer located inside the insulating base material 11. The first substrate 10 may include, for example, a plurality of insulating base materials 11 laminated in the thickness direction.

The second substrate 20 may have, for example, an electrical conductor layer located inside and/or on the surface of the insulating base material 21.

### Second Embodiment

FIG. 2 is a cross-sectional view illustrating an example of the wiring board according to a second embodiment. As illustrated in FIG. 2, the wiring board 1 may have a cover electrical conductor layer 30 located on the surface electrical conductor layer 12.

In this way, when the cover electrical conductor layer 30 is provided on the surface electrical conductor layer 12, the thickness of the first region 211 of the insulating base material 21 is less than that of the second region 212 to an even greater extent. The first region 211 may be denser than the second region 212 to an even greater extent. Therefore, for example, in the wiring board 1 in which the plurality of interlayer connection conductors 22 are located in the insulating base material 21 of the second substrate 20, the moisture is even less likely to enter the interlayer connection conductors 22. As a result, the wiring board 1 can further reduce the deterioration in the insulation resistance.

Note that the thickness of the covering conductor layer 30 may be less than the thickness of the surface electrical conductor layer 12. Specifically, the thickness of the cover electrical conductor layer 30 may be, for example, 0.1 µm or more. The upper limit of the thickness of the cover electrical conductor layer 30 may be, for example, the thickness of the surface electrical conductor layer 12.

The thickness of the surface electrical conductor layer 12 may be, for example, 0.2 µm or more and 20 µm or less. Here, the thicknesses of the surface electrical conductor layer 12 and the cover electrical conductor layer 30 refer to average thickness of each of the layers. The average thickness is an average value obtained by dividing the total sum of the thicknesses of the surface electrical conductor layer 12 or the cover electrical conductor layer 30 at each point when the surface electrical conductor layer 12 or the cover electrical conductor layer 30 is divided into equal portions in one direction, for example, by the number of measurement points in a cross section of the wiring board 1.

The surface electrical conductor layer 12 may be included in the second substrate 20 instead of the first substrate 10.

The cover electrical conductor layer 30 may be, for example, a metalized film that is a sintered body of a conductive paste film, or a plated film. When the cover electrical conductor layer 30 is a plated film, a sintering treatment may be performed in which heating is performed after plating. The sintering treatment can be performed at a temperature of, for example, 600°C to 1000°C. For example, when the plated film is made of a base metal such as copper or nickel, the sintering treatment may be performed in a reducing atmosphere using nitrogen gas.

### Third Embodiment

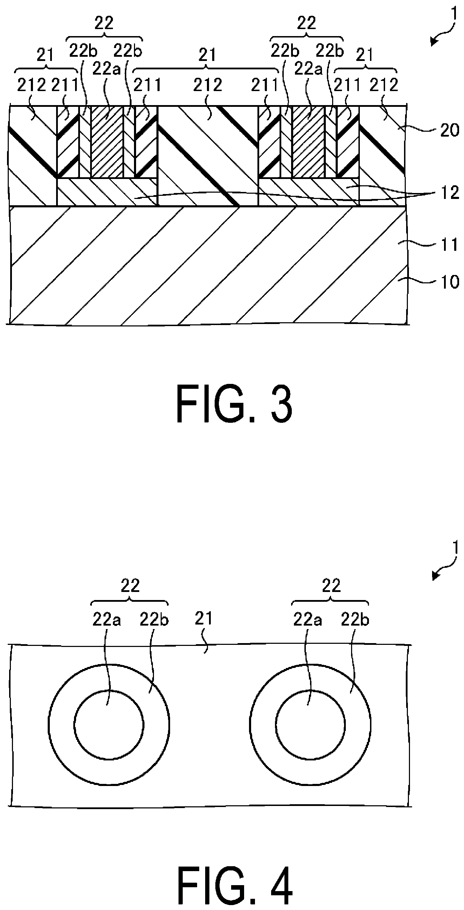

FIG. 3 is a cross-sectional view illustrating an example of the wiring board according to a third embodiment. FIG. 4 is an enlarged plan view illustrating a part of the wiring board illustrated in FIG. 3. As illustrated in FIGs. 3 and 4, in the wiring board 1, the interlayer connection conductor 22 constituting the second substrate 20 may include an inner region 22a and an outer peripheral region 22b. Here, the inner region 22a is located inside the outer peripheral region 22b when the second substrate 20 is viewed in a plan view. In other words, the inner region 22a is surrounded by the outer peripheral region 22b. The outer peripheral region 22b is located such that a resin component thereof forms a strip shape in the longitudinal direction of the interlayer connection conductor 22 (the thickness direction of the second substrate 20). A region in which the resin component is located so as to form the strip shape in the longitudinal direction (thickness direction) of the interlayer connection conductor 22 may be referred to as a mixed region. The mixed region is a region in which the resin component and a metal described below are mixed. The inner region 22a may contain less of the resin component than the outer peripheral region 22b, or may have almost no resin component. The strip shape is, in other words, a long shape. Here, the long shape is a shape having an aspect ratio of, for example, 2 or more. Specifically, the long shape is obtained when a cross section obtained by cutting or polishing the wiring board 1 is observed using an electron microscope and photographed, and when the shape of the resin component in the interlayer connection conductor 22 seen in the photograph is a shape having the aspect ratio defined above.

In the outer peripheral region 22b, the resin component is contained in a gap between a metal that is a conductive material constituting the interlayer connection conductor 22, and the resin component is located so as to have the strip shape. Therefore, the interlayer connection conductor 22 has a lower porosity in the outer peripheral region 22b than in the inner region 22a, and thus the moisture is even less likely to enter the interlayer connection conductor 22. As a result, the wiring board 1 can further reduce the deterioration in the insulation resistance.

Here, the resin component present in the outer peripheral region 22b of the interlayer connection conductor 22 may be, for example, an organic resin component contained in the insulating base material 21 of the second substrate 20.

For example, when a raw sheet of the second substrate 20 (filled with a conductive paste serving as a material of the interlayer connection conductors 22) is laminated on the first substrate 10 and heated and pressed, the resin component present in the outer peripheral region 22b may move from the insulating base material 21 of the second substrate 20, and may form, in the outer peripheral region 22b, the mixed region present in the strip shape in the longitudinal direction of the interlayer connection conductor 22.

The width of the mixed region, that is, the thickness of the outer peripheral region 22b along a radial direction of the interlayer connection conductor 22 is determined by the pressure, temperature, and duration of the pressurization and heating applied at the time of lamination and pressure bonding.

The thickness of the outer peripheral region 22b along the radial direction of the interlayer connection conductor 22 may be, for example, 1/6 or more and 1/2 or less of the outer diameter of the interlayer connection conductor 22.

As illustrated in FIG. 4, the outer peripheral region 22b is preferably made so as to surround the inner region 22a of the interlayer connection conductor. In other words, if the resin component contained in the outer peripheral region 22b is extracted from the interlayer connection conductor 22, the resin component may have a cylindrical shape.

The resin component is preferably not present in the inner region 22a located radially on the inner side of the interlayer connection conductor 22. As a result, the wiring board 1 can secure the electrical conductivity of the interlayer connection conductor 22.

### Fourth Embodiment

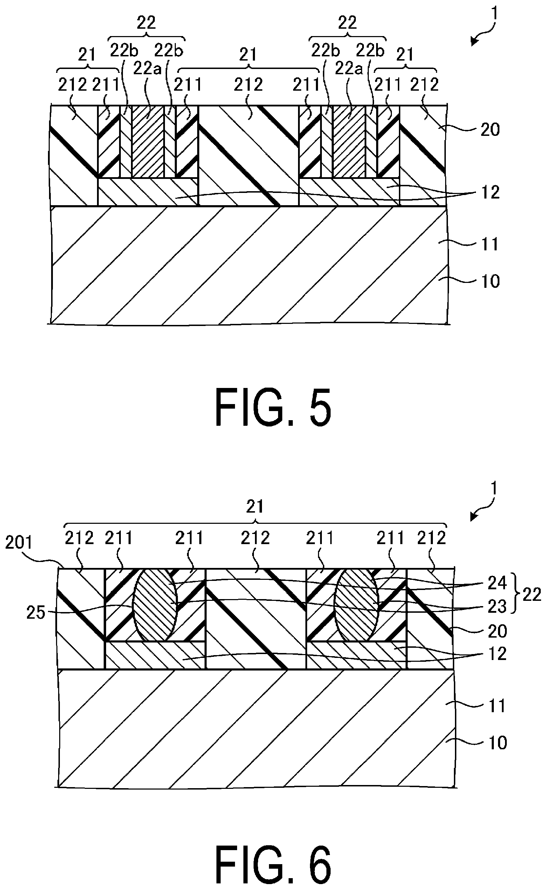

FIG. 5 is a cross-sectional view illustrating an example of the wiring board according to a fourth embodiment. In FIG. 5 also, the interlayer connection conductor 22 will be described separately for the inner region 22a and the outer peripheral region 22b, in the same or similar manner as/to FIG. 3.

As described above, the interlayer connection conductor 22 contains a metal component. In particular, this interlayer connection conductor 22 contains a particulate metal. Hereinafter, the particulate metal may also be referred to as metal particles. In the interlayer connection conductor 22, the outer peripheral region 22b has a greater ratio of the metal particles than that of the inner region 22b located on the inner side of the outer peripheral region 22a. In the outer peripheral region 22b, a region excluding the metal particles is preferably filled with a resin component. Due to the larger amount of the resin component present in the outer peripheral region 22b, the bonding between the metal particles is weakened in the outer peripheral region 22b. The resin component has a lower elastic modulus than the metal. The wiring board 1 described here has a structure in which the outer peripheral region 22a containing the larger amount of the resin component than the inner region 22b is provided on a side in contact with the insulating base material 21. For this reason, with this wiring board 1, it is easy to reduce stress generated due to a difference in the coefficient of thermal expansion between the interlayer connection conductor 22 and the insulating base material 21 of the second substrate 20 located around the interlayer connection conductor 22. Therefore, an occurrence of a defect such as separation of the interlayer connection conductor 22 from the insulating base material 21 surrounding the interlayer connection conductor 22 can be suppressed. As a result, the wiring board 1 can further reduce the deterioration in the insulation resistance.

Here, the aspect ratio of the shape of the particulate metal (metal particle) appearing in a cross-sectional view of the wiring board 1 is preferably 2 or less, for example. When the interlayer connection conductor 22 constituting the wiring board 1 includes the metal particle having such an aspect ratio, the binding force in the metal becomes less than that in an ingot in which the metals are integrated with each other without any gap.

On the other hand, the metals located in the inner region 22a preferably have a shape in which the metals are connected to each other. As a result of a conductor in which the metals are connected to each other being formed in the inner region 22a, for example, the interface resistance between the metal particles adjacent to each other is reduced and the electrical conductivity is increased. Note that the inner region 22a may have voids within a range in which a desired electrical conductivity can be obtained.

### Fifth Embodiment

FIG. 6 is a cross-sectional view illustrating an example of the wiring board according to a fifth embodiment. As illustrated in FIG. 6, in the interlayer connection conductor 22 of the wiring board 1, the diameter of a portion 24 close to the surface 201 of the second substrate 20 may be smaller than the diameter of a portion 23 located at the center in the thickness direction of the second substrate 20.

Since an outer circumferential surface 25 of the interlayer connection conductor 22 facing the insulating base material 21 of the second substrate 20 has a partially rounded shape, the surface area of the interlayer connection conductor 22 is reduced, and the interlayer connection conductor 22 becomes less likely to be deformed by an external pressure. For example, even when the second substrate 20 made of an organic resin is significantly deformed, a deformation amount of the interlayer connection conductor 22 is likely to remain smaller than that of the second substrate 20. Thus, the mounting reliability of an electric element electrically mounted on the interlayer connection conductor 22 can be enhanced.

As illustrated in FIG. 6, in the wiring board 1, the diameter of the interlayer connection conductor 22 may gradually decrease from the vicinity of the center in the thickness direction of the second substrate 20 toward end portions thereof. As a result, the interlayer connection conductor 22 is likely to have a mechanical effect similar to an effect obtained by the shape thereof changing from a polyhedral shape to a spherical shape, and the wiring board 1 is thus less likely to deform or break.

Around the end portion of the interlayer connection conductor 22 located near the surface 201 of the second substrate 20, the organic resin of the insulating base material 21 may enter deeply toward the center in the radial direction of the interlayer connection conductor 22 so as to surround the interlayer connection conductor 22, for example. Thus, the deformation of the interlayer connection conductor 22 can be further reduced. As a result, in the wiring board 1, for example, even when the electric element is mounted on the surface 201 of the second substrate 20 with a high pressure, the interlayer connection conductor 22 is less likely to deform. Note that, in addition to the configuration described above, the diameter of a portion of the interlayer connection conductor 22 close to the surface electrical conductor layer 12 may be smaller than the diameter of the portion located at the center in the thickness direction of the second substrate 20.

### Other Embodiments

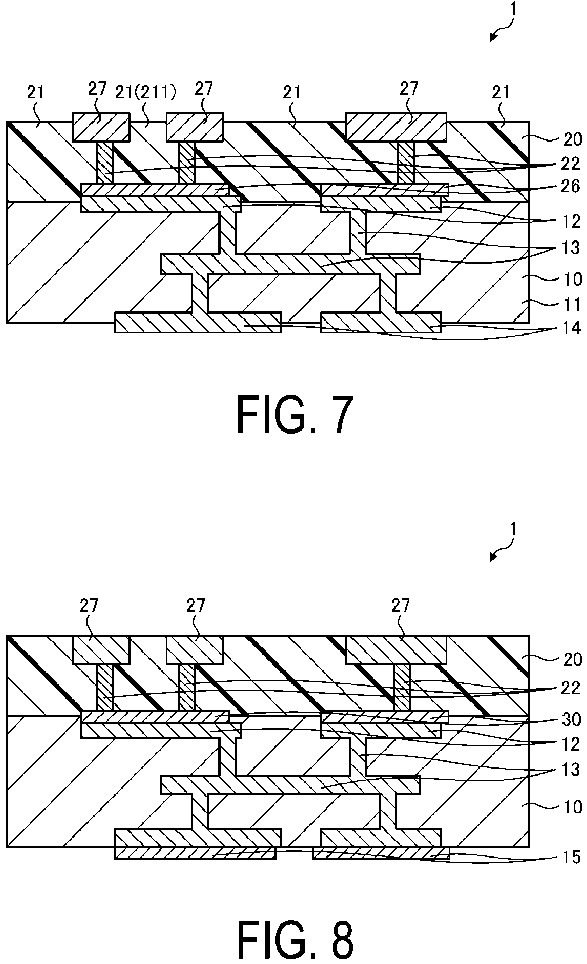

FIGs. 7 and 8 are each a cross-sectional view illustrating another example of the wiring board according to an embodiment.

The wiring board 1 may have an electrical conductor layer 13 located inside the insulating base material 11. Alternatively, the second substrate 20 may include an electrical conductor layer (for example, an electrical conductor layer 26 (see FIG. 7) or a surface wiring layer 27 (see FIGs. 7 and 8)) located on the surface or inside of the insulating base material 21.

For example, when the thickness of the first substrate 10 is 1, the thickness of the second substrate 20 may be in a range of 0.05 to 0.2. When the thickness of the second substrate 20 made of an organic resin having a low elastic modulus is less than the thickness of the first substrate 10 made of ceramic, the first substrate 10 is less likely to deform due to a load such as a load caused by thermal expansion of the wiring board 1 or a load of the wiring board 1.

The conductor of the second substrate 20 (in particular, the surface wiring layer 27 and the interlayer connection conductor 22) may be finer than, for example, the conductor of the first substrate 10 (in particular, a surface wiring layer 15 and the electrical conductor layer 13). As a result, it becomes easier to mount an electric element having a fine circuit such as an LSI or another semiconductor element, on the second substrate 20 side. Here, being fine means in particular that the width of the conductor is small. In the conductors formed at the first substrate 10 and the second substrate 20, the width of a so-called signal line is preferably smaller than the width of the signal line formed at the first substrate 10. As a result, the second substrate 20 can be suppressed from becoming hard and becoming difficult to deform.

### Experimental Example

The wiring boards 1 according to samples 1 to 6 described below were produced, and their characteristics were evaluated.

### Production of Sample 1

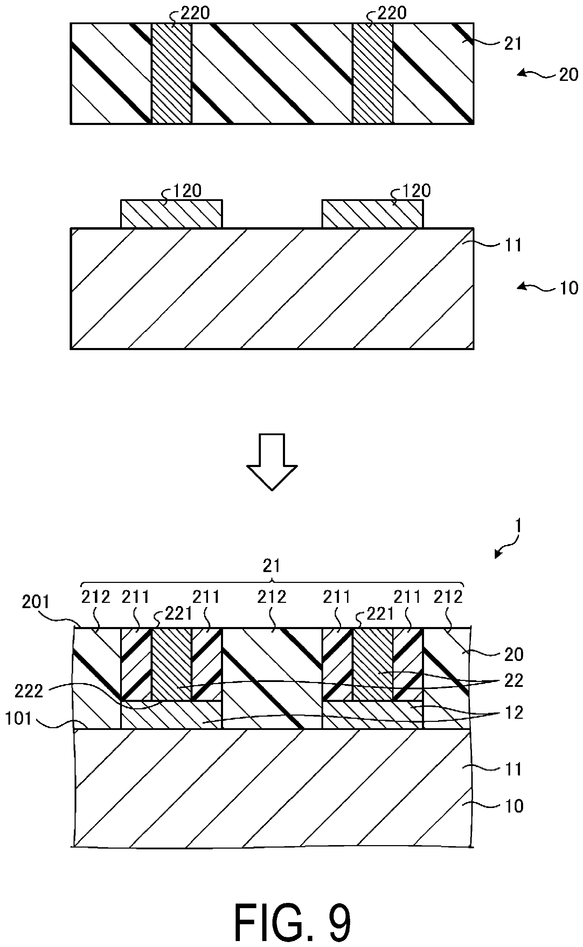

FIG. 9 is an explanatory diagram illustrating an example of a method of manufacturing the wiring board according to Sample 1. First, the first substrate 10 and the second substrate 20 were prepared. The first substrate 10 includes copper metalized films 120 on a surface of the insulating base material 11 made of glass ceramic. The metalized film 120 protrudes from the surface of the insulating base material 11 by a thickness close to the thickness of the surface electrical conductor layer 12.

The second substrate 20 includes interlayer connection conductors 220, prior to curing, penetrating the insulating base material 21 in the thickness direction thereof. The insulating base material 21 was produced using a thermosetting epoxy resin as an organic material (resin component) thereof. The interlayer connection conductor 220 prior to curing contains 50 mole% of copper powder, 25 mole% of Sn powder, 25 mole% of Bi powder, and an epoxy resin as a remaining portion.

Subsequently, the first substrate 10 and the second substrate 20 were stacked together, and pressurized and heated at a temperature of 75°C and a pressure of 3Pa for 15 seconds in a vacuum atmosphere. By the operation described above, the wiring board 1 (Sample 1: see FIG. 1) was obtained in which the interlayer connection conductors 22 of the second substrate 20 were located on the surface electrical conductor layers 12 of the first substrate 10.

In the wiring board 1 according to Sample 1, since the surface electrical conductor layer 12 protruding from the surface of the first substrate 10 is provided, the insulating base material 21 (first region 211) of the second substrate 20 located on the surface electrical conductor layer 12 is pressurized to a greater extent than the second region 212, which is a region of the insulating base material 21 other than the first region 211 under which the surface electrical conductor layer 12 is present, and thus becomes denser.

### Production of Sample 2

A nickel plated film was formed on the surface of the surface electrical conductor layer 12 of the first substrate 10 used in Sample 1, and a sintering treatment was performed at a temperature of 700°C in a nitrogen atmosphere. As a result, the wiring board 1 (Sample 2: see FIG. 2) was obtained that included the cover electrical conductor layer 30 on the surface electrical conductor layer 12.

### Production of Sample 3

The wiring board 1 (Sample 3: see FIGs. 3 and 4) in which an organic resin was located around the interlayer connection conductors 22 was obtained by performing the same or similar processing as that of Sample 1 except that the pressurization and heating were performed for 30 seconds.

### Production of Sample 4

The wiring board 1 (Sample 4: see FIG. 5) was obtained that had the outer peripheral region 22b having a greater ratio of the particulate metal than the inner region 22a by performing the same or similar processing as/to that of Sample 1 except that an amount of a curing agent (amine-based) to be contained in the organic material (resin component) serving as the insulating base material 21 of the second substrate 20 was 1.2 times that of Sample 1.

### Production of Sample 5

By performing the same or similar processing as/to that of Sample 4 except that a raw sheet was used that was harder than the material of the insulating base material 21 used for the second substrate 20 of Sample 4, the wiring board 1 (Sample 5: see FIG. 6) was obtained that included the interlayer connection conductor 22, which was obtained by the interlayer connection conductor 220, prior to curing, deforming, and as a result, the diameter of the portion of the interlayer connection conductor 22 close to the surface of the second substrate 20 becoming smaller than the diameter of the portion thereof located at the center in the thickness direction of the second substrate 20. As the raw sheet harder than the material of the insulating base material 21 used for the second substrate 20 of Sample 4, an organic material having a glass transition temperature higher than that of the organic material used for Sample 4 by 20°C was used.

In each of the produced Samples 1, 2, 3, 4, and 5, the first substrate 10 included the copper metalized film 120 on the surface of the insulating base material 11, as the surface electrical conductor layer 12. The metalized film 120 included the surface electrical conductor layer 12 and protruded from the surface of the insulating base material 11 by a thickness close to the thickness of the surface electrical conductor layer 12. In all of the samples (1 to 5), the ratio of the total area of voids in the first region 211 of the insulating base material 21 was lower than that in the second region 212 with a difference of 0.5% or more. In this case, voids having a diameter of 0.1 µm or more were extracted.

### Production of Sample 6

The wiring board (a comparative example) including the insulating base material 21 having a uniform density was obtained by performing the same processing as that of Sample 1 except that the first substrate 10 that did not include the metalized film 120 on the surface of the insulating base material 11 was used. Sample 6 had the same ratio of the total area of voids in portions corresponding to the first region and the second region of the insulating base material, respectively. In this case, when the difference between the numerical values of the ratio of the total area of voids was within 1%, those values were determined to be the same values.

### Evaluation

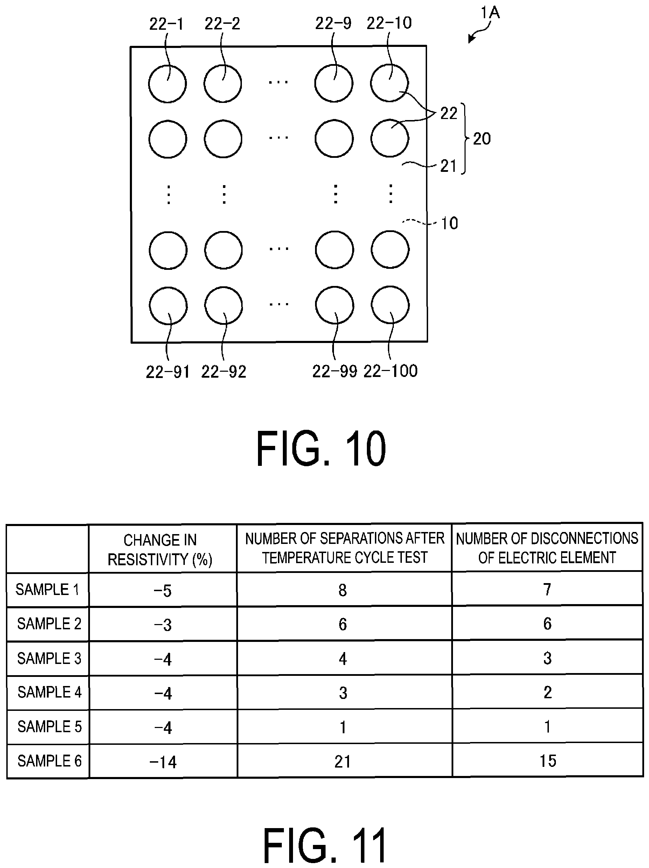

FIG. 10 is a plan view illustrating wiring boards according to Samples 1 to 6. As illustrated in FIG. 10, in wiring boards 1A according to Samples 1 to 6, the diameter of the interlayer connection conductor 22 is 100 µm, the interval between the adjacent interlayer connection conductors 22 is 50 µm, and a total of 100 of the interlayer connection conductors 22 are positioned in 10 rows × 10 columns. These interlayer connection conductors 22 are connected to each other in series.

Under an environment of 130°C and 85% Rh, a voltage of 5.5 V was applied for 168 Hr between the adjacent interlayer connection conductors 22 to perform a high-temperature high-humidity bias test (HAST test). The falling rate of the insulation resistance was measured using a value before the test as a reference, and the results are shown in FIG. 11. Note that the values of the falling rate shown in FIG. 10 are average values of four points (between the interlayer connection conductors 22-1 and 22-2, between 22-9 and 22-10, between 22-91 and 22-92, and between 22-99 and 22-100).

In addition, a temperature cycle test in which the environmental temperature was changed from -55°C to 125°C was performed on each of the wiring boards according to Samples 1 to 6. The presence or absence of separation between the interlayer connection conductor 22 and the insulating base material 21 after 5000 cycles was visually evaluated, and the numbers of the interlayer connection conductors 22 with which the separation was confirmed are shown in FIG. 11.

With respect to the wiring boards according to Samples 1 to 6, the mounting reliability of the electric element mounted on the interlayer connection conductor 22 was evaluated. The presence or absence of disconnection of the electric element mounted on the interlayer connection conductor 22 was visually evaluated, and the numbers of the interlayer connection conductors 22 with which the disconnection was confirmed are shown in FIG. 11.

FIG. 11 is a diagram showing evaluation results of the wiring boards according to Samples 1 to 6. As shown in FIG. 11, in all of the wiring boards 1 according to Samples 1 to 5, the effect of reducing the deterioration in the insulation resistance was confirmed, as compared with the wiring board according to Sample 6.

In all of the wiring boards 1 according to Samples 1 to 5, the effect of reducing the separation between the interlayer connection conductor 22 and the insulating base material 21 after the temperature cycle test was confirmed, as compared with the wiring board according to Sample 6.

Furthermore, in all of the wiring boards 1 according to Samples 1 to 5, the effect of reducing the disconnection of the electric element mounted on the interlayer connection conductor 22 was confirmed, as compared with the wiring board according to Sample 6.

As described above, in the wiring board 1 according to the embodiments, the wiring board 1 includes the first substrate 10, the surface electrical conductor layer 12, and the second substrate 20, which are laminated in this order. The second substrate 20 includes the insulating base material 21 made of an organic material. The surface electrical conductor layer 12 is located on the surface of the first substrate 10 and protrudes from that surface. The second substrate 20 includes the plurality of interlayer connection conductors 22. The interlayer connection conductor 22 extends in the thickness direction of the second substrate 20, and the one end thereof is exposed from the surface of the second substrate 20. The surface electrical conductor layer 12 is electrically connected to the interlayer connection conductor 22. The insulating base material 21 of the second substrate 20 includes the first region 211 and the second region 212. The first region 211 is located on the surface electrical conductor layer 12. The second region 212 is located on the surface of the first substrate 10. The first region 211 has a greater density than the second region 212.

Therefore, the wiring board 1 according to the embodiments can reduce the deterioration in the insulation resistance.

Additional effects and other aspects can be easily derived by a person skilled in the art. Thus, a wide variety of aspects of the present disclosure are not limited to the specific details and representative embodiments represented and described above. Accordingly, various changes are possible without departing from the spirit or scope of the general inventive concepts defined by the appended claims and their equivalents.

### REFERENCE SIGNS

1 Wiring board
10 First substrate
11, 21 Insulating base material
12 Surface electrical conductor layer
20 Second substrate
22 Interlayer connection conductor
22a Inner region
22b Outer peripheral region
30 Cover electrical conductor layer
211 First region
212 Second region

## Claims

1. A wiring board comprising:
a first substrate;
a surface electrical conductor layer; and
a second substrate containing an organic material as an insulating base material, wherein
the first substrate, the surface electrical conductor layer, and the second substrate are laminated in this order,
the surface electrical conductor layer is located on a surface of the first substrate,
the second substrate comprises a plurality of interlayer connection conductors,
the interlayer connection conductor extends in a thickness direction of the second substrate, and one end of the interlayer connection conductor is exposed from a surface of the second substrate,
the surface electrical conductor layer and the interlayer connection conductor are electrically connected to each other,
the insulating base material of the second substrate comprises a first region and a second region,
the first region is located on the surface electrical conductor layer,
the second region is located on the surface of the first substrate, and
the first region has a greater density than a density of the second region.

2. The wiring board according to claim 1, comprising
a cover electrical conductor layer located on a surface of the surface electrical conductor layer.

3. The wiring board according to claim 1 or 2, wherein
the interlayer connection conductor contains a resin component, and
the resin component is located in an outer peripheral region of the interlayer connection conductor and forms a strip shape in the thickness direction of the second substrate.

4. The wiring board according to claim 3, wherein
the interlayer connection conductor contains a metal particle,
in a plan view of the second substrate, the interlayer connection conductor comprises the outer peripheral region comprising an outer edge of the interlayer connection conductor, and an inner region extending through a central axis of the interlayer connection conductor and located on an inner side of the outer peripheral region, and
a volume ratio of the metal particle in the outer peripheral region is greater than a volume ratio of the metal particle in the inner region.

5. The wiring board according to any one of claims 1 to 4, wherein
in the interlayer connection conductor, a diameter of a portion close to the surface of the second substrate is smaller than a diameter of a portion located at a center in the thickness direction of the second substrate.

6. The wiring board according to claim 5, wherein
in the interlayer connection conductor, a diameter of a portion close to the surface electrical conductor layer is smaller than the diameter of the portion located at the center in the thickness direction of the second substrate.
